# EUROPEAN PATENT APPLICATION

(11) **EP 4 138 118 A1**
(43) Date of publication of application: **22.02.2023**
(21) Application number: 21789078.9
(22) Date of filing: 22.03.2021
(51) Int. Cl.: H01L 21/365, H01L 21/368, C23C 16/448, C23C 16/455

(54) **FILM-FORMING DEVICE AND FILM-FORMING METHOD**

(30) Priority: 13.04.2020 JP 2020071898
(71) Applicant: SHIN-ETSU CHEMICAL CO., LTD., Tokyo 1000005 (JP)
(72) Inventor: SAKATSUME, Takahiro, Annaka-shi, Gunma 379-0195 (JP)
(74) Representative: Sonnenhauser, Thomas Martin
(86) International application number: PCT/JP2021/011578
(87) International publication number: WO 2021/210350

(57) **Abstract**

The present invention is a film forming apparatus comprising, a mist-forming unit that turns a raw material solution into mist and generates mist, a pipe that is connected to the mist-forming unit and transfers a carrier gas containing the mist, at least one pipe for transferring an additive fluid containing one or more types of gas as a main component to be mixed with the carrier gas containing the mist, a pipe that is connected to a film forming unit and transfers a mixed mist fluid that is a mixture of the carrier gas containing the mist and the additive fluid, a connecting member connecting the pipe for transferring the carrier gas containing the mist, the pipe for transferring the additive fluid, and the pipe for transferring the mixed mist fluid, a film forming unit that heat-treats the mist to form a film on a substrate, wherein an angle between the pipe for transferring the additive fluid and the pipe for transferring the mixed mist fluid, which are connected by the connecting member, is 120 degrees or more. This provides a film forming apparatus to which a mist CVD method having an excellent film forming rate can be applied.

## Description

### TECHNICAL FIELD

The present invention relates to a film forming apparatus and a film forming method for forming a film on a substrate using a mist-like raw material.

### BACKGROUND ART

Conventionally, high vacuum film forming apparatus capable of realizing a non-equilibrium state such as pulsed laser deposition (PLD), molecular beam epitaxy (MBE), sputtering method, etc. has been developed so far. It has become possible to produce oxide semiconductors, which could not be produced by melt growth method or the like.

In addition, a mist chemical vapor deposition (Mist CVD) method for growing a crystal on a substrate using an atomized mist-like raw material has been developed. It has become possible to fabricate gallium oxide (α-Ga₂O₃) having a corundum structure. As a semiconductor with a large bandgap, α-Ga₂O₃ is expected to be applied to next-generation switching devices capable of achieving high breakdown voltage, low loss, and high heat resistance.

Regarding the mist CVD method, Patent Document 1 discloses a tube furnace type mist CVD apparatus. Patent Document 2 discloses a fine channel type mist CVD apparatus. Patent Document 3 discloses a linear source type mist CVD apparatus. Patent Document 4 discloses a mist CVD apparatus for a tube furnace, and is different from the mist CVD apparatus disclosed in Patent Document 1 that a carrier gas is introduced into a mist generator. Patent Document 5 discloses a mist CVD apparatus in which a substrate is installed above a mist generator and a susceptor is a rotary stage provided on a hot plate.

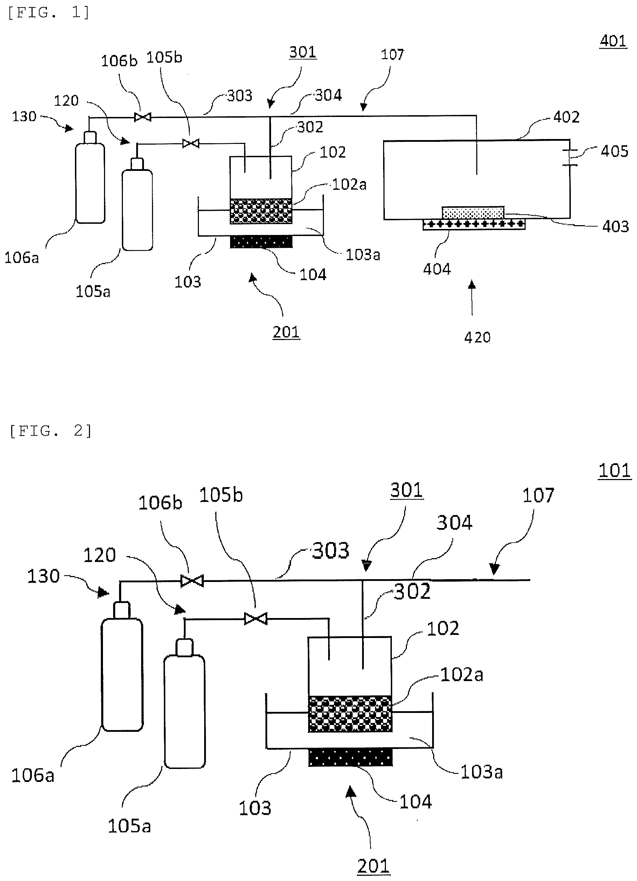

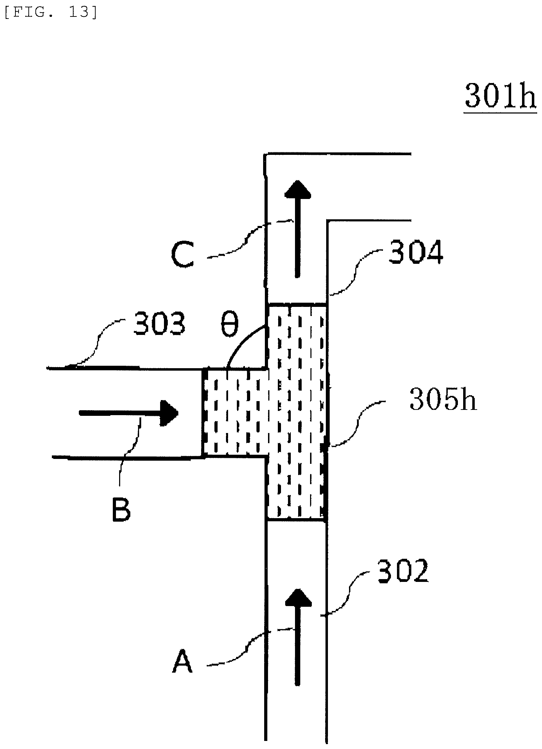

FIG. 13 shows an enlarged view of a connecting portion 301h of a pipe for transferring a carrier gas containing mist and a pipe for transferring the diluent gas, in FIG. 1 of Patent Document 6. As shown in FIG. 13, in Patent Document 6, a mist CVD apparatus is disclosed in which a pipe 303 for transferring an additive fluid which is a diluent gas is connected at a right angle to each of a pipe 302 for transferring a carrier gas containing mist and a pipe 304 for transferring a mixed mist fluid, and the mist produced in a raw material supply unit is transferred by the carrier gas, a diluent gas (additive fluid) having a flow vector B of the additive fluid is mixed to the carrier gas containing the mist having a flow vector A in a orthogonal manner, and a flow vector C of the mixed mist fluid is arranged parallel to the flow vector A of the carrier gas containing mist. By using a diluent gas, a linear velocity of the mixed mist fluid can be adjusted independently of the amount of mist transferred, and by using a supply means that supplies such a mixed mist fluid in opposite directions, the in-plane film thickness distribution is improved.

### CITATION LIST

### PATENT LITERATURE

Patent Document 1: JP H01-257337 A
Patent Document 2: JP 2005-307238 A
Patent Document 3: JP 2012-46772 A
Patent Document 4: JP 5397794 B2
Patent Document 5: JP 2014-63973 A
Patent Document 6: JP 2020-2396 A
Patent Document 7: JP 2020-2426 A

### SUMMARY OF INVENTION

### TECHNICAL PROBLEM

Unlike other CVD methods, the mist CVD method can form a film at a relatively low temperature, and can also produce a metastable phase crystal structure such as a corundum structure of α-Ga₂O₃.

However, the present inventor has found a new problem that the film forming rate is lowered due to lowering of efficiency of transfer of the mist, since, the mist collides with the pipe due to the additive fluid which is a diluent gas and condensation occurs during the transfer of the mist, and/or the additive fluid flows back to the pipe of the carrier gas containing the mist. This problem becomes more remarkable as the flow rate increased, that is, when film formation is performed on a large-area substrate or a plurality of substrates that required a large amount of gas. To solve such a problem, Patent Document 7 discloses a mist CVD apparatus that extends the life of the mist and improves the film forming rate by heating the mist transfer portion. However, even if this method is used, the decrease in the film forming rate is not completely eliminated.

The present invention has been made to solve the above problems. It is an object of the present invention to provide a film forming apparatus to which a mist CVD method having an excellent film forming rate can be applied, and a film forming method having an excellent film forming rate.

### SOLUTION TO PROBLEM

The present invention has been made to achieve the above object, and provides a film forming apparatus at least comprising, a mist-forming unit that turns a raw material solution into mist and generates mist, a pipe that is connected to the mist-forming unit and transfers a carrier gas containing the mist, at least one pipe for transferring an additive fluid containing one or more types of gas as a main component to be mixed with the carrier gas containing the mist, a pipe that is connected to a film forming unit and transfers a mixed mist fluid that is a mixture of the carrier gas containing the mist and the additive fluid, a connecting member connecting the pipe for transferring the carrier gas containing the mist, the pipe for transferring the additive fluid, and the pipe for transferring the mixed mist fluid, a film forming unit that heat-treats the mist to form a film on a substrate, wherein an angle between the pipe for transferring the additive fluid and the pipe for transferring the mixed mist fluid, which are connected by the connecting member, is 120 degrees or more.

According to such a film forming apparatus, the backflow of the additive fluid to the pipe for transferring the carrier gas containing mist can be suppressed by a simple apparatus configuration. In addition, the reduction of mist due to collision with the wall surface of the connecting portion can be suppressed, and the film forming rate can be improved.

At this time, the angle between the pipe for transferring the additive fluid and the pipe for transferring the mixed mist fluid is 180 degrees.

As a result, the backflow of the additive fluid to the pipe for transferring the carrier gas containing mist can be further suppressed. Further, the reduction of mist due to the collision of the connecting portion with the pipe wall surface can be further suppressed, and the film forming rate can be further improved.

At this time, a linear velocity of the additive fluid can be 1 to 100 times to a linear velocity of the carrier gas containing the mist.

This can further suppress the reduction of mist due to collision with the wall surface of the connecting portion, and it becomes possible to transfer the mist more stably, because the low-speed carrier gas containing mist is attracted to the high-speed additive fluid at the connecting portion due to an ejector effect, and it becomes possible to further improve the film forming rate.

Further, the present invention provides a film forming apparatus at least comprising, a mist-forming unit that turns a raw material solution into mist and generates mist, a pipe that is connected to the mist-forming unit and transfers a carrier gas containing the mist, at least one pipe for transferring an additive fluid containing one or more types of gas as a main component to be mixed with the carrier gas containing the mist, a pipe that is connected to a film forming unit and transfers a mixed mist fluid that is a mixture of the carrier gas containing the mist and the additive fluid, a connecting member connecting the pipe for transferring the carrier gas containing the mist, the pipe for transferring the additive fluid, and the pipe for transferring the mixed mist fluid, a film forming unit that heat-treats the mist to form a film on a substrate, wherein an angle between the pipe for transferring the additive fluid and the pipe for transferring the mixed mist fluid, which are connected by the connecting member, is 100 degrees or more, and a linear velocity of the additive fluid at a connecting portion is equal to or higher than the linear velocity of the carrier gas containing the mist.

According to such a film forming apparatus, the backflow of the additive fluid to the pipe for transferring the carrier gas containing mist can be suppressed by a simple apparatus configuration even when a large flow rate of gas is flowed. In addition, the reduction of mist due to collision with the wall surface of the connecting portion can be suppressed, and the film forming rate can be improved.

At this time, the film forming apparatus can be formed in which the angle between the pipe for transferring the additive fluid and the pipe for transferring the mixed mist fluid is 120 degrees or more.

As a result, the backflow of the additive fluid to the pipe for transferring the carrier gas containing mist can be further suppressed. Further, the reduction of mist due to the collision of the connecting portion with the pipe wall surface can be further suppressed, and the film forming rate can be further improved.

At this time, the film forming apparatus can be such that the linear velocity of the additive fluid at the connecting portion is 10 times or more to the linear velocity of the carrier gas containing the mist.

This can further suppress the reduction of mist due to collision with the wall surface of the connecting portion, and it becomes possible to transfer the mist more stably, because the low-speed carrier gas containing mist is attracted to the high-speed additive fluid at the connecting portion due to the ejector effect, and it becomes possible to further improve the film forming rate.

At this time, the film forming apparatus can be such that a cross-sectional area of a portion of the connecting member connected to the pipe for transferring the additive fluid is equal to or less than a cross-sectional area of a portion of the connecting member connected to the pipe for transferring the carrier gas containing the mist.

As a result, if the flow rate of the additive fluid is low, the linear velocity of the additive fluid can be increased, and the degree of freedom of the linear velocity of the mist is increased, which is industrially advantageous.

At this time, the film forming apparatus can have a flow rate of the carrier gas of 8 L/min or more.

As a result, even in the case of film formation on a large-area substrate that requires a large flow rate, it becomes possible to form a film at a higher film formation rate.

At this time, the film forming apparatus is capable of processing the substrate having an area of 10 cm² or more.

This makes it possible to form a film over a large area at a faster film forming rate.

Further, the present invention provides a film forming method comprising, a process of mist-forming a raw material solution in a mist-forming unit to generate mist, a process of supplying a carrier gas to the mist-forming unit and transferring a carrier gas containing the mist from the mist-forming unit, a step of mixing the carrier gas containing the mist and at least one type of additive fluid containing one or more types of gas as a main component to form a mixed mist fluid, a process of transferring the mixed mist fluid to a film formation unit, a process of heat-treating the mist in the mixed mist fluid to form a film on a substrate in the film forming unit, wherein an angle formed by a flow vector of the additive fluid and a flow vector of the mixed mist fluid is 60 degrees or less in the step of forming the mixed mist fluid.

According to such a film forming method, the backflow of the additive fluid to the pipe for transferring the carrier gas containing mist can be suppressed. Further, the reduction of mist due to the collision of the connecting portion with the pipe wall surface can be suppressed. Thus, transfer efficiency of the mist can be increased and the film forming rate can be improved.

At this time, the angle formed by the flow vector of the additive fluid and the flow vector of the mixed mist fluid can be set to 0 degree.

As a result, the backflow of the additive fluid to the pipe for transferring the carrier gas containing mist can be further suppressed, the transfer efficiency of the mist can be further improved, and the film forming rate can be further improved.

At this time, the linear velocity of the additive fluid can be 1 to 100 times to the linear velocity of the carrier gas containing the mist.

This makes it possible to further improve the mist transfer efficiency, and it becomes possible to transfer the mist more stably, because the low-speed carrier gas containing mist is attracted to the high-speed additive fluid at the connecting portion due to an ejector effect, and it becomes possible to further improve the film forming rate.

The present invention also provides a film forming method comprising, a process of mist-forming a raw material solution in a mist-forming unit to generate mist, a process of supplying a carrier gas to the mist-forming unit and transferring the carrier gas containing the mist from the mist-forming unit, a step of mixing the carrier gas containing the mist and at least one type of additive fluid containing one or more types of gas as a main component to form a mixed mist fluid, a process of transferring the mixed mist fluid to the film forming unit, a process of heat-treating the mist in the mixed mist fluid to form a film on a substrate in the film forming unit, wherein an angle formed by a vector of a flow of the additive fluid and a vector of a flow of the mixed mist fluid is set to 80 degrees or less in the step of forming the mixed mist fluid, and a linear velocity of the additive fluid at a connecting portion is equal to or higher than a linear velocity of the carrier gas containing the mist.

According to such a film forming method, the backflow of the additive fluid to the pipe for transferring the carrier gas containing mist can be suppressed. Further, the reduction of mist due to the collision of the connecting portion with the pipe wall surface can be suppressed. Thus, transfer efficiency of the mist can be increased and the film forming rate can be improved.

At this time, the angle formed by the flow vector of the additive fluid and the flow vector of the mixed mist fluid can be set to 60 degrees or less.

As a result, the backflow of the additive fluid to the pipe for transferring the carrier gas containing mist can be further suppressed, the transfer efficiency of the mist can be further improved, and the film forming rate can be further improved.

At this time, the linear velocity of the additive fluid at the connecting portion can be 10 times or more to the linear velocity of the carrier gas containing the mist.

This makes it possible to further improve the mist transfer efficiency, and it becomes possible to transfer the mist more stably, because the low-speed carrier gas containing mist is attracted to the high-speed additive fluid at the connecting portion due to the ejector effect, and it becomes possible to further improve the film forming rate.

At this time, the flow rate of the carrier gas can be set to 8 L/min or more.

As a result, even in the case of film formation on a large-area substrate that requires a large flow rate, it becomes possible to form a film at a higher film formation rate.

At this time, a substrate having an area of 10 cm² or more can be used as the substrate.

This makes it possible to form a film over a large area at a faster film forming rate.

### ADVANTAGEOUS EFFECTS OF INVENTION

As described above, according to the film forming apparatus of the present invention, the backflow of the additive fluid to the pipe for transferring the carrier gas containing mist can be suppressed, the reduction of mist due to collision with the wall surface of the connecting portion can be suppressed, the mist transfer efficiency can be fine, and the film forming rate can be greatly improved by a simple apparatus configuration. Further, according to the film forming method of the present invention, it becomes possible to greatly improve the mist transport efficiency and the film forming rate by a simple method.

### BRIEF DESCRIPTION OF DRAWINGS

FIG. 1 is a schematic configuration diagram of a film forming apparatus according to the present invention;
FIG. 2 is a schematic configuration diagram of a raw material supply system in the film forming apparatus according to the present invention;
FIG. 3 is a diagram illustrating an example of a mist-forming unit of a raw material supply system in the film forming apparatus according to the present invention;
FIG. 4 is a diagram illustrating an example of a connecting portion of a raw material supply system in the film forming apparatus according to the present invention;
FIG. 5 is a diagram illustrating another example of a connecting portion of a raw material supply system in the film forming apparatus according to the present invention;
FIG. 6 is a diagram illustrating another example of a connecting portion of a raw material supply system in the film forming apparatus according to the present invention;
FIG. 7 is a diagram illustrating another example of a connecting portion of a raw material supply system in the film forming apparatus according to the present invention;
FIG. 8 is a diagram illustrating another example of a connecting portion of a raw material supply system in the film forming apparatus according to the present invention;
FIG. 9 is a diagram illustrating another example of a connecting portion of a raw material supply system in the film forming apparatus according to the present invention;
FIG. 10 is a diagram illustrating a connecting portion of a raw material supply system in the film forming apparatus used in Example 13;
FIG. 11 is a diagram showing the results of the examples;
FIG. 12 is a diagram showing the results of the examples;
FIG. 13 is a diagram illustrating an example of a connecting portion of a raw material supply system in a conventional film forming apparatus.

### DESCRIPTION OF EMBODIMENTS

Hereinafter, the present invention will be described in detail, but the present invention is not limited thereto.

As described above, there has been a demand for a film forming apparatus to which a mist CVD method having an excellent film forming rate can be applied, and a film forming method having an excellent film forming rate.

As a result of diligent studies on the above mentioned problems, the present inventor has found that a film forming apparatus at least comprising, a mist-forming unit that turns a raw material solution into mist and generates mist, a pipe that is connected to the mist-forming unit and transfers a carrier gas containing the mist, at least one pipe for transferring an additive fluid containing one or more types of gas as a main component to be mixed with the carrier gas containing the mist, a pipe that is connected to a film forming unit and transfers a mixed mist fluid that is a mixture of the carrier gas containing the mist and the additive fluid, a connecting member connecting the pipe for transferring the carrier gas containing the mist, the pipe for transferring the additive fluid, and the pipe for transferring the mixed mist fluid, a film forming unit that heat-treats the mist to form a film on a substrate, wherein an angle between the pipe for transferring the additive fluid and the pipe for transferring the mixed mist fluid, which are connected by the connecting member, is 120 degrees or more, can be applied to a mist CVD method having an excellent film forming rate and completed the invention.

The present inventor also has found that a film forming apparatus at least comprising, a mist-forming unit that turns a raw material solution into mist and generates mist, a pipe that is connected to the mist-forming unit and transfers a carrier gas containing the mist, at least one pipe for transferring an additive fluid containing one or more types of gas as a main component to be mixed with the carrier gas containing the mist, a pipe that is connected to a film forming unit and transfers a mixed mist fluid that is a mixture of the carrier gas containing the mist and the additive fluid, a connecting member connecting the pipe for transferring the carrier gas containing the mist, the pipe for transferring the additive fluid, and the pipe for transferring the mixed mist fluid, a film forming unit that heat-treats the mist to form a film on a substrate, wherein an angle between the pipe for transferring the additive fluid and the pipe for transferring the mixed mist fluid, which are connected by the connecting member, is 100 degrees or more, and a linear velocity of the additive fluid at a connecting portion is equal to or higher than the linear velocity of the carrier gas containing the mist can be applied to a mist CVD method having an excellent film forming rate and completed the invention.

Also, the present inventor has found that the film forming method comprising, a process of mist-forming a raw material solution in a mist-forming unit to generate mist, a process of supplying a carrier gas to the mist-forming unit and transferring a carrier gas containing the mist from the mist-forming unit, a step of mixing the carrier gas containing the mist and at least one type of additive fluid containing one or more types of gas as a main component to form a mixed mist fluid, a process of transferring the mixed mist fluid to a film formation unit, a process of heat-treating the mist in the mixed mist fluid to form a film on a substrate in the film forming unit, wherein an angle formed by a flow vector of the additive fluid and a flow vector of the mixed mist fluid is 60 degrees or less in the step of forming the mixed mist fluid can be a film forming method having excellent film forming rate and completed the invention.

Further, the present inventor has found that the film forming method comprising, a process of mist-forming a raw material solution in a mist-forming unit to generate mist, a process of supplying a carrier gas to the mist-forming unit and transferring the carrier gas containing the mist from the mist-forming unit, a step of mixing the carrier gas containing the mist and at least one type of additive fluid containing one or more types of gas as a main component to form a mixed mist fluid, a process of transferring the mixed mist fluid to the film forming unit, a process of heat-treating the mist in the mixed mist fluid to form a film on a substrate in the film forming unit, wherein an angle formed by a vector of a flow of the additive fluid and a vector of a flow of the mixed mist fluid is set to 80 degrees or less in the step of forming the mixed mist fluid, and a linear velocity of the additive fluid at a connecting portion is equal to or higher than a linear velocity of the carrier gas containing the mist can be a film forming method having excellent film forming rate and completed the invention.

Hereinafter, description will be made with reference to the drawings.

Here, the mist in the present invention refers to a general term for fine particles of a liquid dispersed in a gas, and includes those called mist, droplets, or the like.

The film forming apparatus according to the present invention comprises at least, a mist-forming unit that turns a raw material solution into mist and generates mist, a pipe that is connected to the mist-forming unit and transfers a carrier gas containing the mist, at least one pipe for transferring an additive fluid containing one or more types of gas as a main component to be mixed with the carrier gas containing the mist, a pipe that is connected to a film forming unit and transfers a mixed mist fluid that is a mixture of the carrier gas containing the mist and the additive fluid, a connecting member connecting the pipe for transferring the carrier gas containing the mist, the pipe for transferring the additive fluid, and the pipe for transferring the mixed mist fluid, a film forming unit that heat-treats the mist to form a film on a substrate. Hereinafter, components of the film forming apparatus according to the present invention will be described in detail. The explanations of matters common to the drawings may be omitted as appropriate.

### (Film formation apparatus)

FIG. 1 shows an example of the film forming apparatus 401 according to the present invention. The film forming apparatus 401 includes a carrier gas supply unit 120, an additive fluid supply unit 130, a mist-forming unit 201, a film forming unit 420 that heat-treats the mist to form a film on a substrate 403, a mixed mist fluid transfer portion 107, and connecting portion 301 that connects the additive fluid supply unit 130, the mist-forming unit 201 and the mixed mist fluid transfer portion 107. Further, the film forming apparatus 401 may be controlled in its operation by providing a control unit (not shown) for controlling the whole or a part of the film forming apparatus 401. Hereinafter, the film forming unit 420 and the raw material supply system 101 (see FIG. 2) on the upstream side of the film forming unit 420 when viewed from the flow of the raw material will be described separately.

### (Raw material supply system)

FIG. 2 shows an example of the raw material supply system 101 according to the present invention. The raw material supply system 101 includes a mist-forming unit 201 that converts the raw material solution 102a into a mist to generate mist, a carrier gas supply unit 120 that supplies a carrier gas that transfers the mist, an additive fluid supply unit 130 that supplies an additive fluid that is mixed with the carrier gas containing the mist, the mixed mist fluid transfer portion 107 that transfers the mixed mist fluid in which the carrier gas containing the mist and the additive fluid are mixed, and a connecting portion 301 that connects the mist-forming unit 201, the additive fluid supply unit 130 and the mixed mist fluid transfer portion 107. The carrier gas supply unit 120 is connected to the additive fluid supply unit 130 and the mixed mist fluid transfer portion 107 via the mist-forming unit 201.

### (Mist-forming unit)

In the mist-forming unit 201, a raw material solution 102a is prepared, and the raw material solution 102a is made into a mist to generate mist. The mist-forming means is not particularly limited as long as the raw material solution 102a can be made into a mist, and may be a known mist-forming means, but it is preferable to use a mist-forming means by ultrasonic vibration. This is because it can be made into mist more stably.

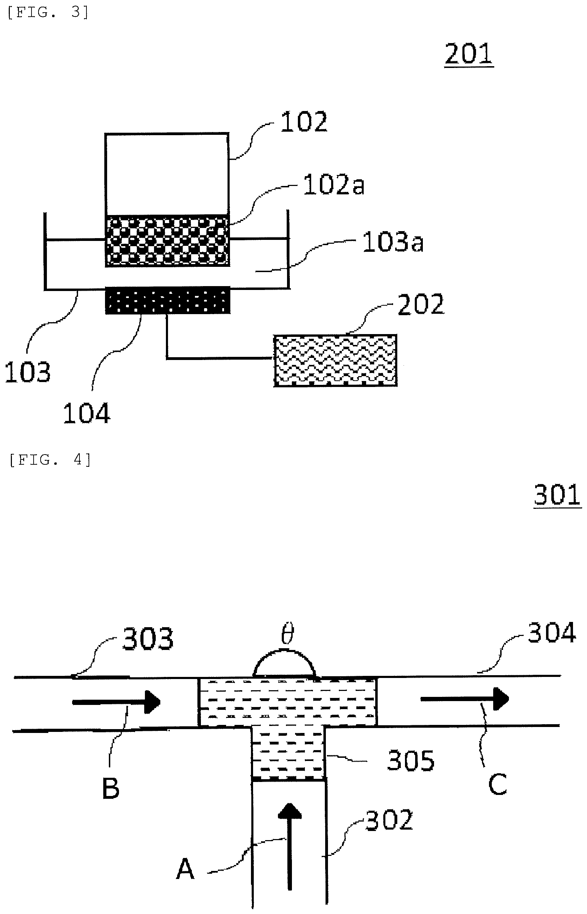

An example of such a mist-forming unit 201 will be described with reference to FIG. 3. For example, the mist-forming unit 201 may include a mist generation source 102 containing a raw material solution 102a, a container 103 containing a medium capable of transmitting ultrasonic vibration, for example, water 103a, and an ultrasonic vibrator 104 attached to the bottom surface of the container 103. Specifically, the mist generation source 102 containing the raw material solution 102a is stored in the container 103 containing water 103a by using a support (not shown). The ultrasonic vibrator 104 is provided at the bottom of the container 103, and the ultrasonic vibrator 104 and an oscillator 202 are connected to each other. Then, when the oscillator 202 is operated, the ultrasonic vibrator 104 vibrates, the ultrasonic propagates into the mist generation source 102 via water 103a, and the raw material solution 102a is configured to become mist.

### (Carrier gas supply unit)

As shown in FIGS. 1 and 2, the carrier gas supply unit 120 has a carrier gas source 105a for supplying the carrier gas. At this time, a flow rate control valve 105b for adjusting the flow rate of the carrier gas sent out from the carrier gas source 105a may be provided.

The type of carrier gas is not particularly limited and can be appropriately selected depending on the film. For example, oxygen, ozone, an inert gas such as nitrogen or argon, or a reducing gas such as hydrogen gas or forming gas can be mentioned. Further, the type of carrier gas may be one type or two or more types. For example, a diluted gas obtained by diluting the same gas as the first carrier gas with another gas (for example, diluted 10-fold) may be further used as the second carrier gas, or air may be used.

Further, the carrier gas may be supplied not only at one port but also at two or more ports. The flow rate of the carrier gas is not particularly limited. For example, when a film is formed on a substrate having a diameter of 4 inches (about 100 mm), it is preferably 1 to 80 L/min, and more preferably 2 to 20 L/min.

The flow rate in the present invention is a measured value at 20°C, and when measured at other temperatures or when a different type of flow rate (mass flow rate or the like) is measured, it can be converted to the volumetric flow rate at 20°C using equation of state of the gas.

### (Additive fluid supply unit)

As shown in FIGS. 1 and 2, the additive fluid supply unit 130 has an additive fluid source 106a for supplying the additive fluid. At this time, a flow rate control valve 106b for adjusting the flow rate of the gas in the additive fluid sent out from the additive fluid source 106a may be provided.

The additive fluid is mainly composed of one or more type of gases. The type of gas is not particularly limited and can be appropriately selected depending on the film. For example, oxygen, ozone, an inert gas such as nitrogen or argon, or a reducing gas such as hydrogen gas or forming gas can be mentioned. Further, the additive fluid may contain mist as long as one or more types of gases are the main components.

Further, the additive fluid may be supplied not only at one port but also at two or more ports. The flow rate of the gas in the additive fluid is not particularly limited. When a film is formed on a substrate having a diameter of 4 inches (about 100 mm), it is preferably 1 to 80 L/min, and more preferably 4 to 40 L/min.

### (Connection portion)

An example of the connecting portion 301 will be described with reference to FIG. 4. The connecting portion 301 includes a pipe 302 for transferring a carrier gas containing mist and connected to the mist-forming unit 201, and a pipe 303 for transferring an additive fluid to be mixed with the carrier gas containing mist in the additive fluid supply unit 130, in a mixed mist fluid transfer portion 107 connected to the film forming unit 402, a pipe 304 for transferring a mixed mist fluid in which a carrier gas containing mist and an additive fluid are mixed, and a connecting member 305 for connecting these pipes.

As the materials of these pipes and connecting members, glass, quartz, vinyl chloride, chlorinated polyether, acrylic resin, fluororesin (perfluoroalkoxyalkane, polytetrafluoroethylene, polychlorotrifluoroethylene), polyethylene, polypropylene, polystyrene and polyurethane are mentioned, but are not limited to these.

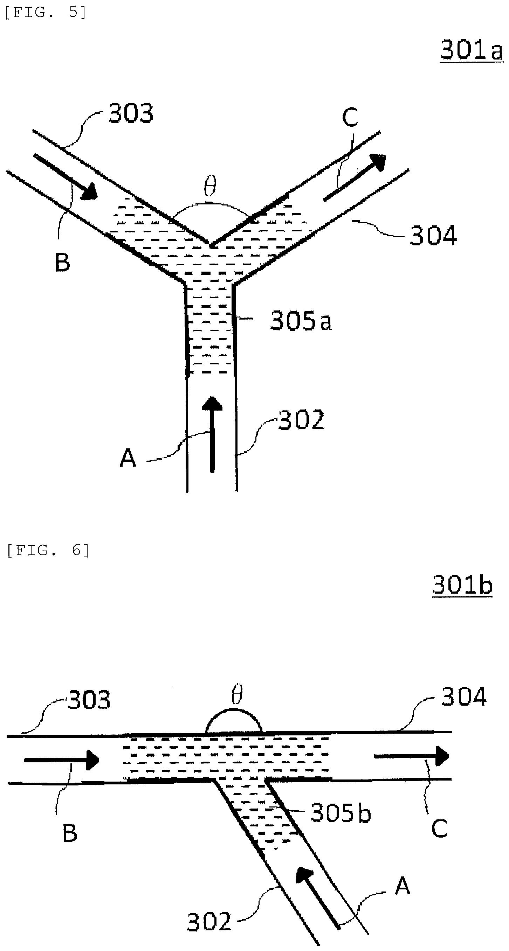

In the film forming apparatus according to the present invention, the connecting portion 301 is connected by the connecting member 305 at an angle θ formed by the pipe 303 for transferring the additive fluid and the pipe 304 for transferring the mixed mist fluid connected by the connecting member 305 of 120 degrees or more. In particular, 180 degrees is more preferable. For example, the connecting portion 301a in FIG. 5 is an example in which the angle θ formed by the pipe 303 for transferring the additive fluid and the pipe 304 for transferring the mixed mist fluid is 120 degrees, and the connecting portion 301 in FIG. 4 is an example of θ of 180 degrees. When the connecting portion 301 is made in the above structure, the angle θ formed by the pipe 303 for transferring the additive fluid and the pipe 304 for transferring the mixed mist fluid is large (120 degrees or more), backflow to the pipe 302 for transferring the carrier gas containing the mist of the additive fluid is suppressed, and no matter how the carrier gas containing the mist is connected, the reduction of the mist due to the collision with the wall surface of the connecting portion can be suppressed. The flow vectors (A to C in the figures) will be described later.

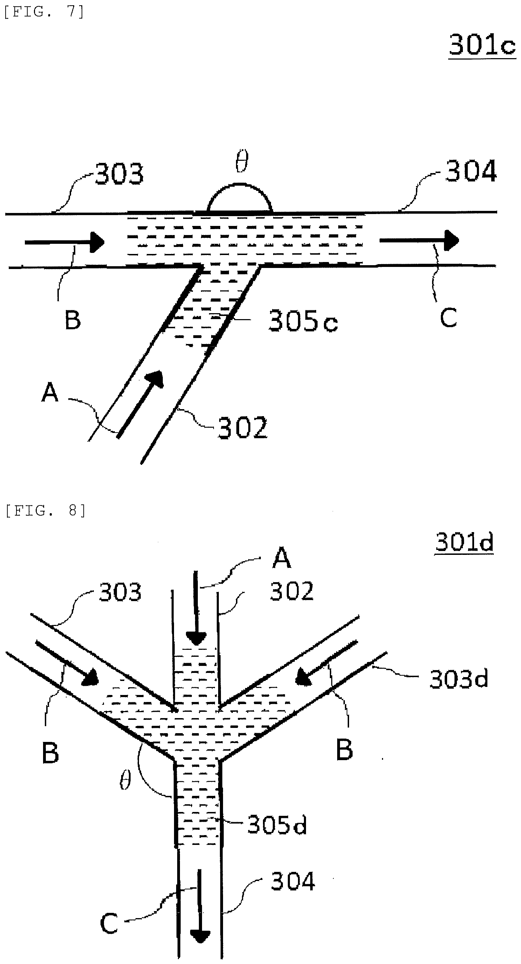

If the angle θ formed by the pipe 303 for transferring the additive fluid and the pipe 304 for transferring the mixed mist fluid is 120 degrees or more, the connecting member 305b of the connecting portion 301b in FIG. 6 and the connecting member 305c of the connecting portion 301c in FIG. 7 or the like the, the direction (connection angle) of the pipe 302 for transferring the carrier gas including the mist is not limited.

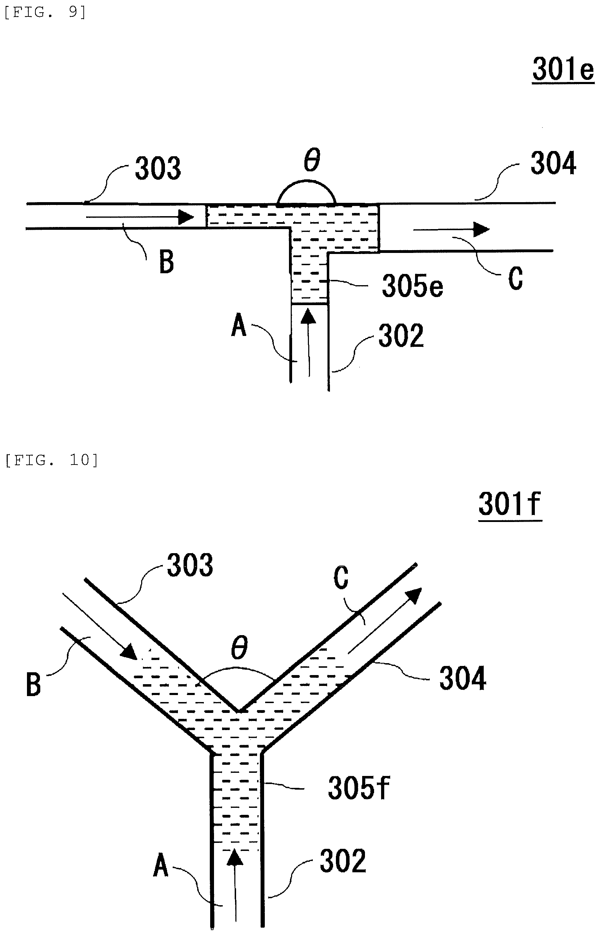

If the angle θ formed by the pipe 303 for transferring the additive fluid and the pipe 304 for transferring the mixed mist fluid is 120 degrees or more, the second pipe 303d for transferring the additive fluid may be connected like the connecting member 305d of the connecting portion 301d as shown in FIG. 8. In this case, the angle formed by each of the pipe 303 for transferring the additive fluid and the second pipe 303d for transferring the additive fluid and the pipe 304 for transferring the mixed mist fluid may be different. Further, as shown in FIG. 9, the thickness and the cross-sectional area of the portions connecting the pipes may be different.

Further, at this time, it is preferable that the linear velocity of the additive fluid is 1 to 100 times the linear velocity of the carrier gas containing mist. In order to do so, the flow rate of each fluid may be controlled by the above-mentioned control unit, or it is also possible by adjusting the flow rate of the additive fluid and the cross-sectional area of the pipe, and the flow rate of the carrier gas including mist and the cross-sectional area of the pipe.

This can further suppress the reduction of mist due to collision with the wall surface of the connecting portion, and the ejector effect attracts the low-speed carrier gas containing mist to the high-speed additive fluid at the connecting portion. It becomes possible to transfer the mist more stably, and it becomes possible to further improve the film forming rate.

In the film forming apparatus according to the present invention, the connecting portion 301 is connected by the connecting member 305 at an angle θ formed by the pipe 303 for transferring the additive fluid and the pipe 304 for transferring the mixed mist fluid connected by the connecting member 305 of 100 degrees or more and the linear velocity of the additive fluid in the connecting portion 301 is set to be equal to or higher than the linear velocity of the carrier gas containing mist. At this time, the angle is particularly preferably 120 degrees or higher, and more preferably 180 degrees. For example, the connecting member 305a of the connecting portion 301a in FIG. 5 is an example in which the angle θ formed by the pipe 303 for transferring the fluid for addition and the pipe 304 for transferring the mixed mist fluid is 120 degrees, and FIG. 4 shows an example in which θ is 180 degrees. When the connecting portion 301 is made in the above structure, the angle θ formed by the pipe 303 for transferring the additive fluid and the pipe 304 for transferring the mixed mist fluid is large (100 degrees or more), backflow of the additive fluid to the pipe 302 for transferring the carrier gas containing the mist is suppressed, and no matter how the carrier gas containing the mist is connected, the reduction of the mist due to the collision with the wall surface of the connecting portion can be suppressed.

Further, at this time, the linear velocity of the additive fluid is not particularly limited as long as the linear velocity of the additive fluid at the connecting portion 301 is equal to or higher than the linear velocity of the carrier gas containing mist. At 10 times or more, the effect of the present invention is further remarkably exhibited. Further, the upper limit of the ratio of linear velocities is not particularly limited. The higher the velocity of the additive fluid, the more remarkable the effect of suppressing the decrease in the film forming rate due to the configuration of the present invention is exhibited. In order to do so, the flow rate of each fluid may be controlled by the above-mentioned control unit, or it is also possible by adjusting the flow rate of the additive fluid and the cross-sectional area of the pipe, and the flow rate of the carrier gas including mist and the cross-sectional area of the pipe. In the connecting portion 301, the cross-sectional area of the portion of the connecting member 305 that is connected to the pipe 303 for transferring the additive fluid is set to be equal to or less than the cross-sectional area of the connecting member 305 that is connected to the pipe 302 for transferring the carrier gas including the mist. For example, as in the connecting member 305e of the connecting portion 301e in FIG. 9, the portion of the connecting member 305e connected to the pipe 303 for transferring the additive fluid is made thinner (the cross-sectional area is made smaller) than the portion connected to other pipes. Therefore, the linear velocity can be increased with a small amount of the additive fluid, and the degree of freedom of the linear velocity of the mist is increased, which is industrially advantageous. Further, if the total amount of gas supplied to the film forming unit is large, the heat of the film forming unit is taken away by the gas, which causes a problem that the crystallinity of the film to be formed is lowered. Therefore, by adopting the configuration as shown in FIG. 9, it is possible to increase the mist transfer efficiency and increase the film forming rate while suppressing the exhaust heat due to the gas.

The linear velocity can be calculated by dividing the volumetric flow rate at 20°C by the cross-sectional area, and when measured at other temperatures or when a different type of flow rate (mass flow rate or the like) is measured, it can be converted to the volumetric flow rate at 20°C using equation of state of the gas.

This can further suppress the reduction of mist due to collision with the wall surface of the connecting portion, and the ejector effect attracts the low-speed carrier gas containing mist to the high-speed additive fluid at the connecting portion. It becomes possible to transfer the mist more stably, and it becomes possible to further improve the film forming rate.

### (Film forming unit)

The film forming unit 420 heats the mist to cause a thermal reaction to form a film on a part or all of the surface of the substrate 403. The film forming unit 420 includes, for example, a film forming chamber 402, a substrate 403 is installed in the film forming chamber 402, and a hot plate 404 for heating the substrate 403 can be provided. The hot plate 404 may be provided outside the film forming chamber 402 as shown in FIG. 1, or may be provided inside the film forming chamber 402. Further, the film forming chamber 402 may be provided with an exhaust gas exhaust port 405 at a position that does not affect the supply of mist to the substrate 403.

Further, in the present invention, the substrate 403 may be installed on the upper surface of the film forming chamber 402 for face-down, or the substrate 403 may be installed on the bottom surface of the film forming chamber 402 for face-up.

Further, it is more preferable that the film forming apparatus can process a film having an area of 10 cm² or more as a substrate in the film forming portion. When the substrate is a circular wafer, it is preferable that it can process, for example, a wafer having a diameter of 2 inches (about 50 mm) or more. With such a film forming apparatus, it is possible to form a film over a large area at a faster film forming rate.

### (Raw material solution)

The raw material solution 102a is not particularly limited as long as it contains a material that can be made into a mist, and may be an inorganic material or an organic material. Metals or metal compounds are preferably used, and those containing one or more metals selected from gallium, iron, indium, aluminum, vanadium, titanium, chromium, rhodium, nickel and cobalt can be used.

The raw material solution 102a is not particularly limited as long as it can mist the metal, but a raw material solution 102a in which the metal is dissolved or dispersed in an organic solvent or water in a form of a complex or a salt can be preferably used. As examples of the form of the complex, an acetylacetonate complex, a carbonyl complex, an ammine complex, and a hydride complex or the like can be mentioned. As examples of the salt form, metal chloride salt, metal bromide salt, metal iodide salt or the like can be mentioned. Further, a solution of the above metal in hydrobromic acid, hydrochloric acid, hydrogen iodide acid or the like can also be used as an aqueous salt solution.

Further, an additive such as a hydrogen halide or an oxidizing agent may be mixed with the raw material solution 102a. As examples of the hydrogen halide, hydrobromic acid, hydrochloric acid, hydroiodide, or the like can be mentioned, and among them, hydrobromic acid or hydroiodide is preferable. As examples of the oxidizing agent, peroxides such as hydrogen peroxide (H₂O₂), sodium peroxide (Na₂O₂), barium peroxide (BaO₂), benzoyl peroxide (C₆H₅CO)₂O₂ or the like, hypochlorous acid (HClO), perchloric acid, nitric acid, ozone water, and organic peroxides such as peracetic acid and nitrobenzene can be mentioned.

Further, the raw material solution 102a may contain a dopant. The dopant is not particularly limited. For example, n-type dopants such as tin, germanium, silicon, titanium, zirconium, vanadium or niobium, or p-type dopants such as copper, silver, tin, iridium and rhodium can be mentioned. The concentration of the dopant may be, for example, about 1 × 10¹⁶ /cm³ to 1 × 10²² /cm³, and even if the concentration can be as low concentration of about 1 × 10¹⁷ /cm³ or less, as a high concentration of about 1 × 10²⁰ /cm³ or more.

### (Substrate)

The substrate 403 is not particularly limited as long as it can form a film and can support the film. The material of the substrate 403 is not particularly limited, and a known substrate can be used, and it may be an organic compound or an inorganic compound. For example, polysulfone, polyether sulfone, polyphenylene sulfide, polyetheretherketone, polyimide, polyetherimide, fluororesin, metals such as iron, aluminum, stainless steel, gold or the like, silicon, sapphire, quartz, glass, gallium oxide, lithium tantalate can be mentioned, but are not limited to these. The thickness of the substrate is not particularly limited, but is preferably 10 to 2000 µm, and more preferably 50 to 800 um. The area of the substrate is not particularly limited, but is preferably 10 cm² or more. When the substrate is a circular wafer, for example, a wafer having a diameter of 2 inches (about 50 mm) or more is preferable. This is because a film can be formed over a large area at a high film forming rate.

Further, the film formation may be performed directly on the substrate, or may be laminated on the intermediate layer formed on the substrate. The intermediate layer is not particularly limited, and for example, an oxide containing any one of aluminum, titanium, vanadium, chromium, iron, gallium, rhodium, indium, and iridium can be a main component. More specifically, they are AlzOs, Ti₂O₃, V₂O₃, Cr₂O₃, Fe₂O₃, Ga₂O₃, Rh₂O₃, In₂O₃, Ir₂O₃. Further, a binary metal oxide represented by (AₓB₁₋ₓ)₂O₃ (0<x<1) where the two elements selected from the above metal elements are A and B, or a ternary metal oxide represented by (AₓB_{y}C_{1-xy})₂O₃ (0<x<1, 0<y<1) where three elements selected from the above metal elements are A, B, and C, can be exemplified.

### (Film forming method)

The film forming method according to the present invention includes a step of mist-forming the raw material solution 102a in the mist-forming unit 201 to generate mist, a step of transferring a carrier gas containing the mist from the mist-forming unit 201 by supplying the carrier gas to the mist-forming unit 201, a step of forming a mixed mist fluid by mixing the carrier gas containing the mist and at least one kind of additive fluid containing one or more kinds of gases as a main component, a step of transferring the a mixed mist fluid to the film forming unit 420 and a step of film forming on the substrate 403 in the film forming unit 420 by heat-treating the mist in the mixed mist fluid. Further, in the step of forming the mixed mist fluid, the angle formed by the vector of the flow of the additive fluid and the vector of the flow of the mixed mist fluid is characterized to be 60 degrees or less.

Hereinafter, an example of the film forming method according to the present invention will be described with reference to FIGS. 1 and 2. One embodiment of the film forming method according to the present invention comprises forming mixed mist fluid by adding additive fluid during transfer of mist by carrier gas to the substrate in the film forming unit, the mist is generated by atomizing or dropletizing the raw material solution in the raw material supply system, and the mist is thermally reacted on the substrate to form a film.

First, the raw material solution 102a is housed in the mist generation source 102, and the substrate 403 is placed directly on the hot plate 404 or through the wall of the film forming chamber 402 to operate the hot plate 404. Next, the flow rate control valve 105b is opened to supply the carrier gas from the carrier gas source 105a into the film forming chamber 402, and the atmosphere of the film forming chamber 402 is sufficiently replaced with the carrier gas, and then the flow rate of the carrier gas and the flow rate of the gas in the additive fluid are adjusted by the flow rate control valves 105b and 106b, respectively.

Next, in the mist-forming unit 201, the ultrasonic vibrator 104 is vibrated and the vibration is propagated to the raw material solution 102a through water 103a to mist the raw material solution 102a and generate mist (a step of generating mist).

Next, the mist is transferred to the connecting portion 301 by the carrier gas supplied to the mist-forming unit 201 (a step of transferring the carrier gas containing the mist from the mist-forming unit).

Then, in the connecting portion 301, a carrier gas containing mist and at least one kind of additive fluid containing one or more kinds of gases as main components are mixed to form a mixed mist fluid (step of forming a mixed mist fluid).

At this time, as shown in FIGS. 4 and 5, in the step of forming the mixed mist fluid, an angle formed by the vector B of the flow of the additive fluid and the vector C of the flow of the mixed mist fluid is set to 60 degrees or less. When the angle formed by the pipe 303 for transferring the additive fluid and the pipe 304 for transferring the mixed mist fluid is θ (degrees), the angle of the above vectors B and C correspond to 180-θ (degrees). That is, as described for the connecting portion 301, the pipe 303 for transferring the additive fluid and the pipe 304 for transferring the mixed mist fluid are connected so that the angle θ formed is 120 degrees or more. For the case of transferring the additive fluid and the mixed mist fluid, it is expressed by "the angle formed by the flow vector B of the additive fluid and the flow vector of the mixed mist fluid", which is 60 degrees or less. In the connecting portion 301, the angle formed by the vector B of the flow of the additive fluid and the vector C of the flow of the mixed mist fluid can be 60 degrees, or it can be 0 degree. In this way, the angle formed by the vector B of the flow of the additive fluid and the vector C of the flow of the mixed mist fluid is set to be 60 degrees or less. In particular, 0 degree is more preferable.

As described above, FIG. 5 shows an example in which the angle θ formed by the pipe 303 for transferring the additive fluid and the pipe 304 for transferring the mixed mist fluid is 120 degrees. When gas flows through such a connecting portion 301, the angle formed by the flow vector B of the additive fluid and the vector C of the flow of the mixed mist fluid is 60 degrees. In the example shown in FIG. 4 (θ = 180 degrees), the angle formed by the vector B of the flow of the additive fluid and the vector C of the flow of the mixed mist fluid is 0 degree.

If the angle between the vector B of the flow of the additive fluid and the vector C of the flow of the mixed mist fluid is 60 degrees or less, the vector A (direction) of the flow of the carrier gas containing the mist is not limited (refer to FIGS. 6 and 7).

Further, at this time, it is preferable that the linear velocity of the additive fluid is 1 to 100 times to the linear velocity of the carrier gas containing mist. For example, the flow rate of the additive fluid and the flow rate of the carrier gas including mist can be adjusted according to the cross-sectional area of each pipe.

As a result, the reduction of mist due to collision with the wall surface of the connecting portion can be further suppressed, and the ejector effect stably attracts the low-speed carrier gas containing mist to the high-speed additive fluid at the connecting portion 301. It becomes possible to transfer the mist more stably, and it becomes possible to further improve the film forming rate.

Further, the mixed mist fluid is transferred to the substrate 403 in the film forming chamber 402 via the mixed mist fluid transfer portion 107 (a step of transferring the mixed mist fluid to the film forming unit). By transferring the mixed mist fluid to the film forming unit in this way, it is possible to improve the efficiency of transferring the mist to the film forming unit 420.

Further, the mist in the mixed mist fluid undergoes a thermal reaction in the film forming chamber 402 due to the heat of the hot plate 404 to form a film on the substrate 403. By supplying the mist in this way, the mist introduced into the film forming chamber 402 is formed on the substrate 403 at a high film forming rate (step of forming a film). The gas in the film forming chamber 402 may be exhausted to the outside from the exhaust port 405 provided above the substrate 403.

The thermal reaction may be such that the mist reacts by heating, and the reaction conditions or the like are not particularly limited. The raw material can be appropriately selected according to the film. For example, the heating temperature can be in a range of 120 to 600 °C, preferably in the range of 200 to 600 °C, and more preferably in the range of 300 to 550 °C.

The thermal reaction may be carried out under any of a vacuum, a non-oxygen atmosphere, a reducing gas atmosphere, an air atmosphere and an oxygen atmosphere, and may be appropriately set according to the film. Further, the reaction pressure may be carried out under any condition of atmospheric pressure, pressurized or reduced pressure, but the film formation under atmospheric pressure is preferable because the apparatus configuration can be simplified.

In the film forming method according to the present invention, in the step of forming the mixed mist fluid, the angle formed by the flow vector of the additive fluid and the flow vector of the mixed mist fluid is set to 80 degrees or less, and the linear velocity of the additive fluid at the connecting portion 301 is equal to or higher than the linear velocity of the carrier gas containing mist.

At this time, as shown in FIGS. 4 and 5, in the step of forming the mixed mist fluid, the angle formed by the vector B of the flow of the additive fluid and the vector C of the flow of the mixed mist fluid is set to 80 degrees or less. When the angle formed by the pipe 303 for transferring the additive fluid and the pipe 304 for transferring the mixed mist fluid is θ (degrees), the angle of the above vectors B and C correspond to 180-θ (degrees). That is, as described with respect to the connecting portion 301, the pipe 303 for transferring the additive fluid and the pipe 304 for transferring the mixed mist fluid are connected so that the angle θ formed thereof is 100 degrees or more, the case of transferring the additive fluid and the mixed mist fluid is expressed by "the angle formed by the flow vector B of the additive fluid and the flow vector of the mixed mist fluid", which is 80 degrees or less. In the connecting portion 301, the angle formed by the vector B of the flow of the additive fluid and the vector C of the flow of the mixed mist fluid can be 60 degrees, or it can be 0 degree. In this way, the angle formed by the vector B of the flow of the additive fluid and the vector C of the flow of the mixed mist fluid is set to be 80 degrees or less. In particular, 60 degrees or less is preferable, and 0 degrees is more preferable.

If the angle between the vector B of the flow of the additive fluid and the vector C of the flow of the mixed mist fluid is 80 degrees or less, the vector A (direction) of the flow of the carrier gas containing the mist is not limited (refer to FIGS. 6 and 7).

Further, at this time, the linear velocity of the additive fluid is not particularly limited as long as the linear velocity of the additive fluid at the connecting portion 301 is equal to or higher than the linear velocity of the carrier gas containing mist. At 10 times or more, the effect of the present invention is further remarkably exhibited. Further, the upper limit of the ratio of linear velocities is not particularly limited. The higher the speed of additive fluid, the more remarkable the effect of suppressing the decrease in the film forming rate due to the configuration of the present invention is exhibited. For example, the flow rate of the additive fluid and the flow rate of the carrier gas containing mist can be adjusted according to the cross-sectional area of each pipe.

As a result, the reduction of mist due to collision with the wall surface of the connecting portion can be further suppressed, and the ejector effect stably attracts the low-speed carrier gas containing mist to the high-speed additive fluid at the connecting portion 301. It becomes possible to transfer the mist stably, and it becomes possible to further improve the film forming rate.

In the present invention, annealing treatment may be performed after film formation. The temperature of the annealing treatment is not particularly limited, but it is preferably 600°C or lower, more preferably 550°C or lower. This is because the crystallinity of the film is not degraded. The treatment time of the annealing treatment is not particularly limited, but it is preferably 10 seconds to 10 hours, and more preferably 10 seconds to 1 hour.

### EXAMPLE

Hereinafter, the present invention will be specifically described with reference to examples, but this does not limit the present invention.

### (Example 1)

First, the film forming apparatus 401 used in the Example 1 will be described with reference to FIG. 1. The used film forming apparatus 401 comprises a carrier gas source 105a for supplying a carrier gas, a flow control valve 105b for adjusting the flow rate of the carrier gas sent out from the carrier gas source 105a, and an additive fluid source 106a for supplying an additive fluid, a flow control valve 106b for adjusting the flow rate of the gas in the additive fluid sent out from the additive fluid source 106a, a mist generation source 102 containing a raw material solution 102a, and a container 103 containing water 103a, an ultrasonic vibrator 104 attached to the bottom surface of the container 103, a film forming chamber 402, and a pipe, a connecting portion 301, and a mixed mist fluid transfer portion 107 connecting the mist generation source 102 to the film forming chamber 402, a hot plate 404 provided outside the film forming chamber 402.

In Example 1, as shown in FIG. 4, the connecting portion 301 uses a T-shaped connecting member 305 to which a pipe 303 for transferring an additive fluid made of perfluoroalkoxy alkane (PFA) and a pipe 304 transferring mixed mist fluid are connected so that the angle formed by these pipes to be 180 degrees, and a pipe 302 made of PFA and transferring carrier gas containing mist is connected to the connecting member 305 so as to form 90 degrees with respect to each of these pipes.

First, a raw material solution was prepared. An aqueous solution of gallium iodide of 0.05 mol/L was prepared, and a 48% hydroiodide solution was further contained so as to have a volume ratio of 10%, which was used as a raw material solution 102a.

The raw material solution 102a obtained as described above was housed in the mist generation source 102. Next, a c-plane sapphire substrate having a diameter of 4 inches (about 100 mm) was placed on the hot plate 404 in the film forming chamber 402 as the substrate 403, and the hot plate 404 was operated to raise the temperature to 450°C.

Next, the flow rate control valve 105b was opened to supply the carrier gas into the film forming chamber 402 from the carrier gas source 105a. After sufficiently replacing the atmosphere of the film forming chamber 402 with the carrier gas, the flow rates of the carrier gas and the additive fluid were adjusted to 8 L/min and 40L /min, respectively. Nitrogen was used as the carrier gas and the additive fluid.

Next, the ultrasonic vibrator 104 was vibrated at 2.4 MHz, and the vibration was propagated to the raw material solution 102a through water 103a to mist the raw material solution 102a and to generate mist. This mist was transferred to the connecting portion 301 by the carrier gas, mixed with the additive fluid in the connecting portion 301, and introduced into the film forming chamber 402 via the mixed mist fluid transfer portion 107. Then, the mist was thermally reacted in the film forming chamber 402 under atmospheric pressure and at 450°C to form a thin film of gallium oxide (α-Ga₂O₃) having a corundum structure on the substrate 403. The film formation time was 30 minutes.

The amount of decrease in the raw material solution 102a in the mist generation source 102 per hour was defined as the time average mist flow rate, and the time average mist flow rate was measured and film forming was performed.

With respect to the thin film formed on the substrate 403, the film thickness was measured using a step meter with measurement points as 17 points in the plane on the substrate 403, and the average film thickness was calculated from each value.

The time average mist flow rate was 3.2 g/min, the average film thickness was 660 nm, and the film forming rate obtained by dividing the average film thickness by the film forming time was 1320 nm/h.

### (Example 2)

As shown in FIG. 5, by using a Y-shaped pipe having θ = 120 degrees as the connecting member 305a, the film was formed and evaluated in the same manner as in Example 1 except that the angle formed by the pipe 303 for transferring the additive fluid and the pipe 304 for transferring the mixed mist fluid, and the angle formed by the pipe 303 for transferring additive fluid and the pipe 302 for transferring the carrier gas containing mist, and the angle between the pipe 304 for transferring the mixed mist fluid and the pipe 302 for transferring the carrier gas containing mist were set to 120 degrees respectively.

The time average mist flow rate was 3.0 g/min, the average film thickness was 590 nm, and the film formation rate was 1180 nm/h.

### (Comparative Example 1)

As shown in FIG. 13, using a T-shaped connecting member 305h having θ = 90 degrees, a film was formed and evaluated in the same manner as in Example 1 except that a pipe 302 for transferring a carrier gas containing mist and made of PFA and a pipe 304 for transferring a mixed mist fluid were connected to the connecting member 305h at an angle formed by these pipes to be 180 degrees, and the pipe 303 for transferring the additive fluid and made of PFA was connected so as to form 90 degrees for each of these pipes.

The time average mist flow rate was 1.7 g/min, the average film thickness was 230 nm, and the film forming rate was 460 nm/h.

### (Example 3)

The film formation and evaluation were carried out in the same manner as in Example 1 except that the flow rate of the carrier gas and the flow rate of the additive fluid were adjusted to 20 L/min and 5 L/min, respectively. The time average mist flow rate was 4.6 g/min, the average film thickness was 1140 nm, and the film formation rate was 2280 nm/h.

### (Comparative Example 2)

The film formation and evaluation were carried out in the same manner as in Comparative Example 1 except that the flow rate of the carrier gas and the flow rate of the additive fluid were adjusted to 20 L/min and 5 L/min, respectively. The time average mist flow rate was 2.7 g/min, the average film thickness was 540 nm, and the film forming rate was 1080 nm/h.

### (Example 4)

The film formation and evaluation were performed in the same manner as in Example 1 except that the flow rate of the carrier gas and the flow rate of the additive fluid were adjusted to 2 L/min and 50 L/min, respectively, and the film formation time was set to 120 minutes. The time average mist flow rate was 0.7 g/min, the average film thickness was 280 nm, and the film forming rate was 140 nm/h.

### (Comparative Example 3)

The film formation and evaluation were performed in the same manner as in Comparative Example 1, except that the flow rate of the carrier gas and the flow rate of the additive fluid were adjusted to 2 L/min and 50 L/min, respectively, and the film formation time was set to 120 minutes. The time average mist flow rate was 0.1 g/min, the average film thickness was 60 nm, and the film formation rate was 30 nm/h.

The results of Examples 1 to 4 and Comparative Examples 1 to 3 are summarized in Table 1.

**[Table 1]**

| | Example 1 | Example 2 | Comparative Example 1 | Example 3 | Comparative Example 2 | Example 4 | Comparative Example 3 |
|---|---|---|---|---|---|---|---|
| An angle between the pipe for the additive fluid and the pipe for the mixed mist fluid (degree) | 180 | 120 | 90 | 180 | 90 | 180 | 90 |
| Ratio of the linear velocity of the additive fluid and the linear velocity of the carrier gas (-) | 20 | 20 | 20 | 1 | 1 | 100 | 100 |
| Time average mist flow rate (g/min) | 3.2 | 3.0 | 1.7 | 4.6 | 2.7 | 0.7 | 0.1 |
| Film forming rate (nm/h) | 1320 | 1180 | 460 | 2280 | 1080 | 140 | 30 |

From the comparison between Examples 1 to 4 and Comparative Examples 1 to 3, it was found that the time average mist flow rate was greatly improved and the film formation rate was also greatly improved, by setting the angle formed by the pipe for transferring the additive fluid and the pipe for transferring the mixed mist fluid to 120 degrees or more.

### (Example 5)

In Example 5, the same apparatus as the film forming apparatus 401 used in Example 1 was used. The differences from the first embodiment will be described below.

In Example 5, as shown in FIG. 9, the connecting portion 301 uses a T-shaped connecting member 305e to which a pipe 303 for transferring an additive fluid made of perfluoroalkoxy alkane (PFA) and a pipe 304 for transferring mixed mist fluid were connected so that the angle formed by these pipes to be 180 degrees, and a pipe 302 made of PFA for transferring carrier gas containing mist was connected to the connecting member 305e so as to form 90 degrees with respect to each of these pipes. At this time, the ratio of the cross-sectional area S_{B} of the portion connected to the pipe 303 for transferring the additive fluid of the connecting member 305e and the cross-sectional area S_{A} of the portion connected to the pipe 302 for transferring the carrier gas containing the mist of the connecting member 305e was defined as α (=S_{A}/S_{B}), α was 20. At this time, the inner diameter of the portion of the connecting member 305e connected to the pipe 303 for transferring the additive fluid was 0.4 cm, and the inner diameter of the portion of the connecting member 305e connected to the pipe 302 for transferring the carrier gas containing the mist was 3.6 cm.

First, a raw material solution was prepared. An aqueous solution of gallium iodide of 0.05 mol/L was prepared, and a 48% hydroiodide solution was further contained so as to have a volume ratio of 10%, which was used as a raw material solution 102a.

The raw material solution 102a obtained as described above was housed in the mist generation source 102. Next, a c-plane sapphire substrate having a diameter of 4 inches (about 100 mm) was placed on the hot plate 404 in the film forming chamber 402 as the substrate 403, and the hot plate 404 was operated to raise the temperature to 450°C.

Next, the flow rate control valve 105b was opened to supply the carrier gas into the film forming 402 from the carrier gas source 105a, and after sufficiently replacing the atmosphere of the film forming chamber 402 with the carrier gas, the flow rate of the carrier gas and the flow rate of the additive fluid were adjusted to 8 L/min and 4 L/min, respectively. Nitrogen was used as the carrier gas and the additive fluid.

Next, the ultrasonic vibrator 104 was vibrated at 2.4 MHz, and the vibration was propagated to the raw material solution 102a through water 103a to mist the raw material solution 102a and generate mist. This mist was transferred to the connecting portion 301 by the carrier gas, mixed with the additive fluid in the connecting portion 301, and introduced into the film forming chamber 402 via the mixed mist fluid transfer portion 107. Then, the mist was thermally reacted in the film forming chamber 402 under atmospheric pressure and at 450°C to form a thin film of gallium oxide (α-Ga₂O₃) having a corundum structure on the substrate 403. The film formation time was 60 minutes.

The amount of decrease in the raw material solution 102a in the mist generation source 102 per hour was defined as the time average mist flow rate, and the time average mist flow rate was measured and film formation was performed.

With respect to the thin film formed on the substrate 403, the film thickness was measured using a step meter with measurement points as 17 points in the plane on the substrate 403, and the average film thickness was calculated from each value. The film formation rate was calculated by dividing the average film thickness by the film formation time.

### (Examples 6 to 8)

The procedure was the same as in Example 5 except that the flow rate of the additive fluid was 10, 20, and 40 L/min.

### (Comparative Example 4)

Using a T-shaped connecting member 305h having θ = 90 degrees, as shown in FIG. 13, a film was formed and evaluated in the same manner as in Example 5 except that a pipe 302 made of PFA for transferring a carrier gas containing mist and a pipe 304 for transferring a mixed mist fluid were connected to the connecting member 305h at an angle formed by these pipes to be 180 degrees, and the pipe 303 made of PFA for transferring the additive fluid was connected so as to form 90 degrees for each of these pipes.

### (Comparative Examples 5 to 7)

The procedure was the same as in Comparative Example 4 except that the flow rate of the additive fluid was 10, 20, and 40 L/min.

### (Example 9)

Changing the shape of the connecting member 305, a film was formed and evaluated in the same manner as in Example 5 except that the ratio α of the cross-sectional area S_{B} of the portion connected to the pipe 303 for transferring the additive fluid of the connecting member 305 and the cross-sectional area S_{A} of the portion connected to the pipe 302 for transferring the carrier gas containing the mist of the connecting member 305 was set to 1 and the flow rate of the additive fluid was set to 8 L/min. At this time, the inner diameter of the portion of the connecting member 305 connected to the pipe 303 for transferring the additive fluid was 1.8 cm, and the inner diameter of the portion of the connecting member 305 connected to the pipe 302 for transferring the carrier gas containing the mist was 1.8 cm.

### (Comparative Example 8)

Changing the shape of the connecting member 305, a film was formed and evaluated in the same manner as in Comparative Example 4 except that the ratio α of the cross-sectional area S_{B} of the portion connected to the pipe 303 for transferring the additive fluid of the connecting member 305 and the cross-sectional area S_{A} of the portion connected to the pipe 302 for transferring the carrier gas containing the mist of the connecting member 305 was set to 1 and the flow rate of the additive fluid was set to 8 L/min. At this time, the inner diameter of the portion of the connecting member 305 connected to the pipe 303 for transferring the additive fluid was 1.8 cm, and the inner diameter of the portion of the connecting member 305 connected to the pipe 302 for transferring the carrier gas containing the mist was 1.8 cm.

### (Example 10)

Changing the shape of the connecting member 305, a film was formed and evaluated in the same manner as in Example 5 except that the ratio α of the cross-sectional area S_{B} of the portion connected to the pipe 303 for transferring the additive fluid of the connecting member 305 and the cross-sectional area S_{A} of the portion connected to the pipe 302 for transferring the carrier gas containing the mist of the connecting member 305 was set to 50 and the flow rate of the additive fluid was set to 24 L/min. At this time, the inner diameter of the portion of the connecting member 305 connected to the pipe 303 for transferring the additive fluid was 0.8 cm, and the inner diameter of the portion of the connecting member 305 connected to the pipe 302 for transferring the carrier gas containing the mist was 5.6 cm.

### (Comparative Example 9)

Changing The shape of the connecting member 305, a film was formed and evaluated in the same manner as in Comparative Example 4 except that the ratio α of the cross-sectional area S_{B} of the portion connected to the pipe 303 for transferring the additive fluid of the connecting member 305 and the cross-sectional area S_{A} of the portion connected to the pipe 302 for transferring the carrier gas containing the mist of the connecting member 305 was set to 50 and the flow rate of the additive fluid was set to 24 L/min. At this time, the inner diameter of the portion of the connecting member 305 connected to the pipe 303 for transferring the additive fluid was 0.8 cm, and the inner diameter of the portion of the connecting member 305 connected to the pipe 302 for transferring the carrier gas containing the mist was 5.6 cm.

### (Example 11)

A film was formed and evaluated in the same manner as in Example 5 except that a Y-shaped pipe having θ = 120 degrees as shown in FIG. 5 was used as the connecting member 305a, and the angle formed by the pipe 303 for transferring the additive fluid and the pipe 304 for transferring the mixed mist fluid, and the angle formed by the pipe 303 for transferring the additive fluid and the pipe 302 for transferring the carrier gas containing mist and the angle formed by the pipe 304 for transferring the mixed mist fluid and the pipe 302 for transferring the carrier gas containing mist were set as 120 degrees respectively.

### (Example 12)

The procedure was the same as in Example 11 except that the flow rate of the additive fluid was set to 40 L/min.

### (Example 13)

A film was formed and evaluated in the same manner as in Example 5 except that a Y-shaped pipe having θ = 100 degrees as shown in FIG. 10 was used as the connecting member 305f, and the angle formed by the pipe 303 for transferring the additive fluid and the pipe 304 for transferring the mixed mist fluid was set as 100 degrees, the angle between the pipe 303 for transferring the additive fluid and the pipe 302 for transferring the carrier gas containing mist, and the angle between the pipe 304 for transferring the mixed mist fluid and the pipe 302 for transferring the carrier gas containing mist were both set to 130 degrees.

### (Example 14)

The procedure was the same as in Example 13 except that the flow rate of the additive fluid was set to 10 L/min.

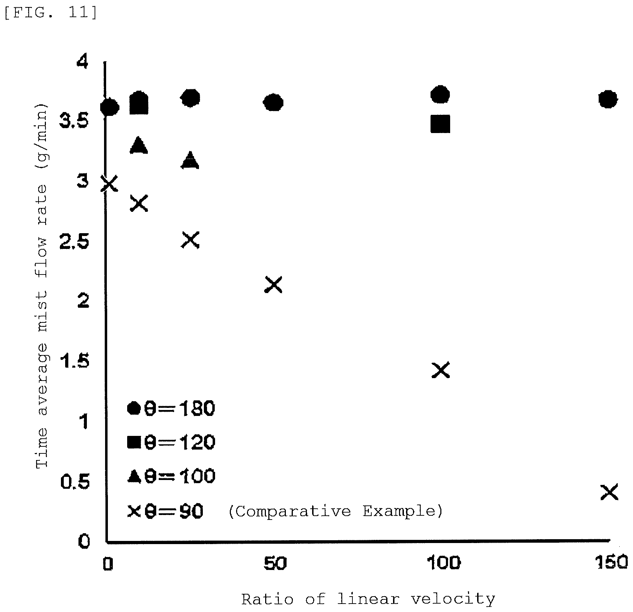

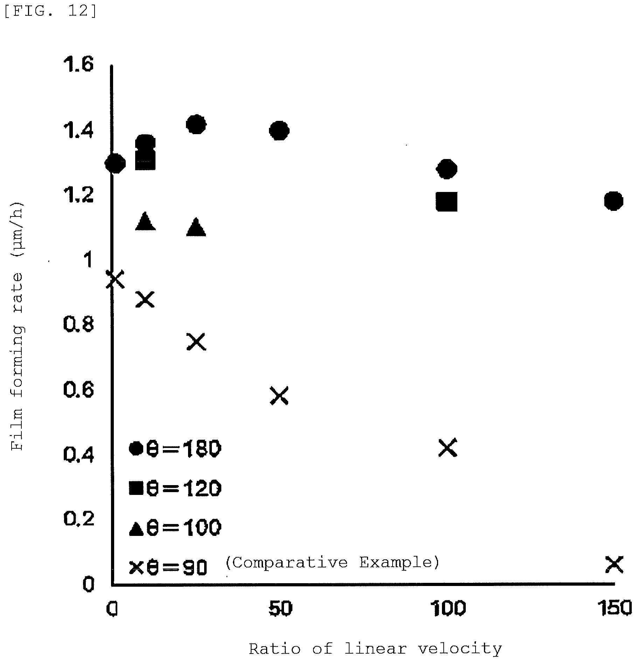

The results of Examples 5 to 14 and Comparative Examples 4 to 9 are summarized in Table 2. The pipe angle represents the angle formed by the pipe for transferring the additive fluid and the pipe for transferring the mixed mist fluid, and the linear velocity ratio represents the value obtained by dividing the linear velocity of the additive fluid by the linear velocity of the carrier gas. Further, FIGS. 11 and 12 show plots of the time average mist flow rate and the film forming rate with respect to the linear velocity ratio.

**[Table 2]**

| | Piping angle (degree) | Carrier gas flew rate (L/min) | Additive fluid flow rate (L/min) | Ratio of cross section area α (-) | Ratio of linear velocity (-) | Time average mist flow rate (g/min) | Film forming rate (µm/hr) |
|---|---|---|---|---|---|---|---|
| Example 5 | 180 | 8 | 4 | 20 | 10 | 3 . 68 | 1.36 |
| Example 6 | 180 | 8 | 10 | 20 | 25 | 3.7 | 1.42 |
| Example 7 | 180 | 8 | 20 | 20 | 50 | 3.66 | 1.4 |
| Example 8 | 180 | 8 | 40 | 20 | 100 | 3.72 | 1.28 |
| Example 9 | 180 | 8 | 8 | 1 | 1 | 3 . 62 | 1.3 |
| Example 10 | 180 | 8 | 24 | 50 | 150 | 3. 67 | 1.35 |
| Example 11 | 120 | 8 | 4 | 20 | 10 | 3. 64 | 1.31 |
| Example 12 | 120 | 8 | 40 | 20 | 100 | 3.48 | 1.18 |
| Example 13 | 100 | 8 | 4 | 20 | 10 | 3.31 | 1.12 |
| Example 14 | 100 | 8 | 10 | 20 | 25 | 3. 18 | 1.1 |
| Comparative Example 4 | 90 | 8 | 4 | 20 | 10 | 2.82 | 0.88 |
| Comparative Example 5 | 90 | 8 | 10 | 20 | 25 | 2.52 | 0.75 |
| Comparative Example 6 | 90 | 8 | 20 | 20 | 50 | 2.14 | 0.58 |
| Comparative Example 7 | 90 | 8 | 40 | 20 | 100 | 1.42 | 0.42 |
| Comparative Example 8 | 90 | 8 | 8 | 1 | 1 | 2.98 | 0.94 |
| Comparative Example 9 | 90 | 8 | 24 | 50 | 150 | 0.4 | 0.06 |

### (Example 15)

A film was formed and evaluated in the same manner as in Example 5 except that a sapphire substrate having a diameter of 6 inches (150 mm) was used, the ratio α of the cross-sectional area S_{B} of the portion connected to the pipe 303 for transferring the additive fluid of the connecting member 305, and cross-sectional area S_{A} of the portion connected to the pipe 302 for transferring the carrier gas containing the mist of the connecting member 305 was set to 1 and the flow rate of the carrier gas and the flow rate of the additive fluid were both set to 20 L/min. At this time, the linear velocity ratio was 1, the inner diameter of the portion of the connecting member 305 connected to the pipe 303 for transferring the additive fluid was 2.6 cm, and the inner diameter of the portion of connecting member 305 connected to the pipe 302 for transferring the carrier gas including mist was 2.6 cm. The time average mist flow rate was 4.65 g/min, and the film formation rate was 1.42 µm/hr.

### (Example 16)

A film was formed and evaluated in the same manner as in Example 11 except that a sapphire substrate having a diameter of 6 inches (150 mm) was used, the ratio α of the cross-sectional area S_{B} of the portion connected to the pipe 303 for transferring the additive fluid of the connecting member 305, and cross-sectional area S_{A} of the portion connected to the pipe 302 for transferring the carrier gas containing the mist of the connecting member 305 was set to 1 and the flow rate of the carrier gas and the flow rate of the additive fluid were both set to 20 L/min. At this time, the linear velocity ratio was 1, the inner diameter of the portion of the connecting member 305 connected to the pipe 303 for transferring the additive fluid was 2.6 cm, and the inner diameter of the portion of connecting member 305 connected to the pipe 302 for transferring the carrier gas including mist was 2.6 cm. The time average mist flow rate was 4.25 g/min, and the film formation rate was 1.26 µm/hr.

### (Example 17)

A film was formed and evaluated in the same manner as in Example 13 except that a sapphire substrate having a diameter of 6 inches (150 mm) was used, the ratio α of the cross-sectional area S_{B} of the portion connected to the pipe 303 for transferring the additive fluid of the connecting member 305, and cross-sectional area S_{A} of the portion connected to the pipe 302 for transferring the carrier gas containing the mist of the connecting member 305 was set to 1 and the flow rate of the carrier gas and the flow rate of the additive fluid were both set to 20 L/min. At this time, the linear velocity ratio was 1, the inner diameter of the portion of the connecting member 305 connected to the pipe 303 for transferring the additive fluid was 2.6 cm, and the inner diameter of the portion of connecting member 305 connected to the pipe 302 for transferring the carrier gas including mist was 2.6 cm. The time average mist flow rate was 4.04 g/min and the film formation rate was 1.06 µm/hr.

### (Comparative Example 10)

A film was formed and evaluated in the same manner as in Comparative Example 4 except that a sapphire substrate having a diameter of 6 inches (150 mm) was used, the ratio α of the cross-sectional area S_{B} of the portion connected to the pipe 303 for transferring the additive fluid of the connecting member 305, and cross-sectional area S_{A} of the portion connected to the pipe 302 for transferring the carrier gas containing the mist of the connecting member 305 was set to 1 and the flow rate of the carrier gas and the flow rate of the additive fluid were both set to 20 L/min. At this time, the linear velocity ratio was 1, the inner diameter of the portion of the connecting member 305 connected to the pipe 303 for transferring the additive fluid was 2.6 cm, and the inner diameter of the portion of connecting member 305 connected to the pipe 302 for transferring the carrier gas including mist was 2.6 cm. The time average mist flow rate was 1.81 g/min, and the film formation rate was 0.43 µm/hr.

From the comparison of Examples 5 to 14 and Comparative Examples 4 to 9, and Examples 15 to 17 and Comparative Example 10, It was found that the time average mist flow rate was greatly improved and the film forming speed was also greatly improved by setting the angle between the pipe for transferring the additive fluid and the pipe for transferring the mixed mist fluid to be 100 degrees or more and by setting the linear velocity of the additive fluid to be equal to or higher than the linear velocity of the carrier gas.

The present invention is not limited to the above embodiments. The above-described embodiments are just examples, and any examples that substantially have the same configuration and demonstrate the same functions and effects as those in the technical concept disclosed in the claims of the present invention are included in the technical scope of the present invention.

## Claims

1. A film forming apparatus at least comprising,
a mist-forming unit that turns a raw material solution into mist and generates mist,
a pipe that is connected to the mist-forming unit and transfers a carrier gas containing the mist,
at least one pipe for transferring an additive fluid containing one or more types of gas as a main component to be mixed with the carrier gas containing the mist,
a pipe that is connected to a film forming unit and transfers a mixed mist fluid that is a mixture of the carrier gas containing the mist and the additive fluid,
a connecting member connecting the pipe for transferring the carrier gas containing the mist, the pipe for transferring the additive fluid, and the pipe for transferring the mixed mist fluid,
a film forming unit that heat-treats the mist to form a film on a substrate,
wherein an angle between the pipe for transferring the additive fluid and the pipe for transferring the mixed mist fluid, which are connected by the connecting member, is 120 degrees or more.

2. The film forming apparatus according to claim 1, wherein an angle between the pipe for transferring the additive fluid and the pipe for transferring the mixed mist fluid is 180 degrees.

3. The film forming apparatus according to claim 1 or 2, wherein a linear velocity of the additive fluid is 1 to 100 times to a linear velocity of the carrier gas containing the mist.

4. A film forming apparatus comprising at least,
a mist-forming unit that turns a raw material solution into mist and generates mist,
a pipe that is connected to the mist-forming unit and transfers a carrier gas containing the mist,
at least one pipe for transferring an additive fluid containing one or more types of gas as a main component to be mixed with the carrier gas containing the mist,
a pipe that is connected to a film forming unit and transfers a mixed mist fluid that is a mixture of the carrier gas containing the mist and the additive fluid,
a connecting member connecting the pipe for transferring the carrier gas containing the mist, the pipe for transferring the additive fluid, and the pipe for transferring the mixed mist fluid,
a film forming unit that heat-treats the mist to form a film on a substrate,
wherein an angle between the pipe for transferring the additive fluid and the pipe for transferring the mixed mist fluid, which are connected by the connecting member, is 100 degrees or more,
and a linear velocity of the additive fluid at a connecting portion is equal to or higher than a linear velocity of the carrier gas containing the mist.

5. The film forming apparatus according to claim 4, wherein the angle between the pipe for transferring the additive fluid and the pipe for transferring the mixed mist fluid is 120 degrees or more.

6. The film forming apparatus according to claim 4 or 5, wherein the linear velocity of the additive fluid at the connecting portion is 10 times or more to the linear velocity of the carrier gas containing the mist.

7. The film forming apparatus according to any one of claims 1 to 6, wherein a cross-sectional area of a portion of the connecting member connected to the pipe for transferring the additive fluid is equal to or less than a cross-sectional area of a portion of the connecting member connected to the pipe for transferring the carrier gas containing the mist.

8. The film forming apparatus according to any one of claims 4 to 7, wherein a flow rate of the carrier gas is 8 L/min or more.

9. The film forming apparatus according to any one of claims 1 to 8, wherein the substrate can be processed with an area of 10 cm² or more.

10. A film forming method comprising,
a process of mist-forming a raw material solution in a mist-forming unit to generate mist,
a process of supplying a carrier gas to the mist-forming unit and transferring a carrier gas containing the mist from the mist-forming unit,
a step of mixing the carrier gas containing the mist and at least one type of additive fluid containing one or more types of gas as a main component to form a mixed mist fluid,
a process of transferring the mixed mist fluid to a film forming unit,
a process of heat-treating the mist in the mixed mist fluid to form a film on a substrate in the film forming unit,
wherein an angle formed by a flow vector of the additive fluid and a flow vector of the mixed mist fluid is 60 degrees or less in the step of forming the mixed mist fluid.

11. The film forming method according to claim 10, wherein the angle formed by the flow vector of the additive fluid and the flow vector of the mixed mist fluid is set to 0 degree.

12. The film forming method according to claim 10 or 11, wherein a linear velocity of the additive fluid is set to 1 to 100 times to a linear velocity of the carrier gas containing the mist.

13. A film forming method comprising,
a process of mist-forming a raw material solution in a mist-forming unit to generate mist,
a process of supplying a carrier gas to the mist-forming unit and transferring the carrier gas containing the mist from the mist-forming unit,
a step of mixing the carrier gas containing the mist and at least one type of additive fluid containing one or more types of gas as a main component to form a mixed mist fluid,
a process of transferring the mixed mist fluid to the film forming unit,
a process of heat-treating the mist in the mixed mist fluid to form a film on a substrate in the film forming unit,
wherein an angle formed by a vector of a flow of the additive fluid and a vector of a flow of the mixed mist fluid is set to 80 degrees or less in the step of forming the mixed mist fluid,
and a linear velocity of the additive fluid at a connecting portion is equal to or higher than a linear velocity of the carrier gas containing the mist.

14. The film forming method according to claim 13, wherein the angle formed by the flow vector of the additive fluid and the flow vector of the mixed mist fluid is 60 degrees or less.

15. The film forming method according to claim 13 or 14, wherein the linear velocity of the additive fluid at the connecting portion is 10 times or more to the linear velocity of the carrier gas containing the mist.

16. The film forming method according to any one of claims 13 to 15, wherein a flow rate of the carrier gas is 8 L/min or more.

17. The film forming method according to any one of claims 10 to 16, wherein the substrate having an area of 10 cm² or more is used as the substrate.
